Europäisches Patentamt

European Patent Office

Office européen des brevets

(19)

(11) Numéro de publication: **0 310 560**
**A2**

(12) **DEMANDE DE BREVET EUROPEEN**

(21) Numéro de dépôt: 88810659.8

(22) Date de dépôt: 26.09.88

(51) Int. Cl.⁴: **C 23 C 26/02**
**C 25 D 5/50**

(30) Priorité: 29.09.87 CH 3761/87

(43) Date de publication de la demande:
05.04.89 Bulletin 89/14

(84) Etats contractants désignés:
AT BE CH DE ES FR GB GR IT LI LU NL SE

(71) Demandeur: **CENTRE SUISSE D'ELECTRONIQUE ET DE MICROTECHNIQUE S.A.**
**Maladière 71**
**CH-2007 Neuchâtel (CH)**

(72) Inventeur: **Tannenberger, Helmuth**
**La Villette**
**CH-1451 Le Château-de-Ste-Croix (CH)**

(74) Mandataire: **Brulliard, Joel**
**c/o CENTRE SUISSE D'ELECTRONIQUE ET DE MICROTECHNIQUE S.A. Maladière 71**
**CH-2007 Neuchâtel (CH)**

(54) **Procédé de revêtement à basse température par une couche dure et produits obtenus par ce procédé.**

(57) Le procédé de l'invention comprend une première phase consistant en un dépôt à basse température d'une couche comprenant au moins un élément métallique susceptible de donner un carbure et une deuxième phase de traitement laser dans un environnement carburant.

Les pièces ainsi traitées présentent une surface dure et résistante à l'usure.

EP 0 310 560 A2

Description

## PROCEDE DE REVETEMENT A BASSE TEMPERATURE PAR UNE COUCHE DURE ET PRODUITS OBTENUS PAR CE PROCEDE

La présente invention concerne, de manière générale, un procédé de revêtement dur à basse température de pièces sensibles à des températures élevées et plus particulièrement un tel procédé pour l'obtention d'une couche comportant au moins un carbure de métal ainsi que les produits obtenus par ce procédé.

Pour obtenir des pièces présentant une surface dure et résistante à l'usure, plusieurs méthodes ou procédés sont connus et, pour certains, largement utilisés. Parmi les matériaux les plus résistants à l'usure se trouvent les carbures métalliques; tels les carbures de tungstène (WC), de titane (TiC) et de chrome ($Cr_3C_2$). Le carbure de tungstène bien connu, quant à lui, est utilisé sous forme d'alliage avec du cobalt (Co) produit par la métallurgie des poudres; il se présente sous forme massive et ne constitue pas, en l'occurence, un revêtement. Des procédés de revêtement connus, par contre, permettent d'obtenir des couches dures de carbure. Ainsi peut-on déposer par CVD, "Chemical Vapor Deposition" ou dépôt chimique en phase vapeur, ou encore par PVD, "Physical Vapor Deposition" ou dépôt physique en phase vapeur, des couches dures de carbure de titane sur des pièces en matériau métallique ou céramique. Toutefois, le procédé CVD requiert des températures supérieures à 800°C et les pièces traitées par PVD atteignent des températures de l'ordre de 300°C à 400°C. D'autres procédés de dépôt de carbures ont été expérimentés en milieu de sels fondus à des températures supérieures à 800°C, notamment par voie électrochimique ou encore par voie "electroless". L'inconvénient majeur des différents procédés mentionnés ci-dessus est la température élevée (typiquement supérieure à 400°C) qu'ils exigent, interdisant de ce fait les matériaux qui sont susceptibles de se déformer à ces températures, tels les alliages de cuivre ou d'aluminium, ou qui perdent leurs propriétés mécaniques, tels les aciers trempés.

Aussi un objet de la présente invention est un procédé permettant de revêtir des pièces d'une couche dure et résistante à l'usure ne présentant pas les inconvénients mentionnés précédemment.

Un autre objet de l'invention est un procédé de revêtement d'une pièce par une couche dure qui n'implique pas d'augmentation excessive de la température de ladite pièce.

Un autre objet de l'invention est un procédé de revêtement d'une pièce par une couche dure comprenant au moins un carbure de métal.

Encore un autre objet de l'invention est un produit muni d'un revêtement dur comprenant au moins un carbure de métal.

Les caractéristiques de l'invention font l'objet des revendications 1 et suivantes.

L'avantage prédominant de l'invention est le fait qu'elle permet de revêtir des pièces déjà usinées et/ou traitées d'une couche dure et mince comprenant un carbure sans modification substantielle des caractéristiques dimensionnelles et/ou mécaniques des pièces de départ. Cela est dû principalement au fait que la masse des pièces reste à basse température (typiquement inférieure à 300°C) pendant tout le procédé de revêtement. Cela permet, en outre, l'utilisation de matériaux à bas point de fusion.

D'autres objets, caractéristiques et avantages de la présente invention apparaîtront plus clairement à la lecture de la description suivant d'exemples de réalisation particuliers; ladite description étant faite à titre purement illustratif.

Exemple 1

La première phase du procédé consiste en un revêtement, par voie galvanique, d'une pièce en acier trempé par un alliage de nickel et de tungstène (Ni-W). Cette phase est en soi connue; un exemple des principaux paramètres en est donné ci-après:
Composition du bain:
$Na_2WO_4$ . $2H_2O$     70,5 g/l
$NiSO_4$ . $6H_2O$     60 g/l
Acide citrique     90 g/l
$(NH_4)_2$ $SO_4$     60 g/l
$NH_3$ aqueux, tel que $6 <$ pH(bain) $< 8$
Température du bain     70°C
Durée du dépôt     30 mn
Epaisseur de la couche (Ni-W) déposée     5μm

La deuxième phase du procédé consiste à effectuer un traitement de carburation du tungstène contenu dans la couche déposée. Ce traitement est réalisé grâce à un balayage de la surface à traiter au moyen d'un faisceau laser dans une atmosphère carburante. Un exemple des conditions de ce traitement est donné ci-après:

Laser $CO_2$
Diamètre du faisceau     400 μm
Longueur des impulsions     0,1 msec.
Fréquence des impulsions     250 Hz
Vitesse de balayage du faisceau     10 mm/sec.
Distance entre deux lignes de balayage     0,1 mm
Atmosphère $CH_4$; pression     0,5 bar

La surface de la pièce ainsi traitée révèle une composition de nickel et de carbure de tungstène sur une épaisseur d'environ 2 μm. Il est clair que les différents paramètres du traitement par laser doivent être choisis de telle sorte que, s'il entraîne une élévation notable de la température de la surface même de la couche, l'élévation de la température de l'intérieur de la couche et, surtout, du matériau de la pièce reste faible. Il en sera notamment ainsi si: la pièce est elle-même refroidie pendant le traitement, la première couche déposée est relativement épaisse ou la vitesse de balayage par le faisceau laser est grande. Bien entendu, ces différents paramètres doivent être définis en fonction de l'application choisie (nature du matériau de la pièce, forme et dimensions de la pièce, etc...).

## Exemple 2

La première phase du procédé consiste en un revêtement, par voie galvanique, d'une cale-étalon par une couche en alliage de cobalt et de tungstène (Co-W). Composition du bain:

Na$_2$WO$_4$ . 2H$_2$O 70,5 g/l
CoSo$_4$ . 7H$_2$O 60 g/l
Acide citrique 90 g/l
(NH$_4$)$_2$ SO$_4$ 60 g/l
NH$_3$ aqueux, tel que 6< pH(bain)< 8
Température du bain 70°C
Epaisseur de la couche (Co-W) déposée 3 μm

La deuxième phase du procédé consiste à revêtir la couche (Co-W) déposée d'une couche de peinture de graphite colloidal, dont l'épaisseur est peu critique, et à effectuer le traitement laser tel que décrit dans l'exemple 1. Après traitement laser, la couche déposée est composée d'un alliage de cobalt et de carbure de tungstène qui présente une très grande résistance à l'usure. L'épaisseur de cette dernière couche est d'environ 2 μm.

Les exemples donnés ci-dessus montrent qu'il est possible de déposer à l'aide d'un procédé à basse température, telle la méthode de dépôt par voie galvanique, une première couche contenant un élément susceptible de produire un carbure lors du traitement laser dans un environnement carburant. On peut utiliser, pour la première couche, un alliage à base de tungstène, tels les alliages tungstène-cobalt ou tungstène-nickel ou tungstène-fer, ou un alliage à base de chrome ou encore d'autres alliages dont un des éléments sera susceptible de donner un carbure. Par ailleurs, le dépôt de la première couche peut être réalisé par d'autres procédés que le dépôt par voie galvanique. Il importe, en premier lieu, que le procédé utilisé n'élève pas la température de la pièce à traiter au-delà du seuil où les propriétés ou caractéristiques de la pièce pourraient être modifiées. Le dépôt de la première couche peut ainsi être réalisé par évaporation, par pulvérisation ("sputtering") ou par pulvérisation ionique ("ion plating"). Bien que ces procédés soient plus coûteux que le dépôt galvanique, ils peuvent être avantageux dans certaines applications, la pulvérisation ionique, par exemple, permettant un dépôt directif.

On conçoit aisément que la présente invention peut être appliquée dans différents domaines de l'industrie. Peuvent être cités à titre d'exemple non limitatif les cales-étalons, les jauges de mesure et les outils de coupe et d'emboutissage.

## Revendications

1. Procédé pour revêtir des pièces sensibles à des températures élevées par une couche dure, résistante à l'usure et comportant au moins un carbure d'un élément métallique, caractérisé en ce qu'il comprend:
- une première étape consistant à revêtir, à basse température, lesdites pièces d'une couche comprenant au moins un élément métallique susceptible de donner un carbure de cet élément; et
- une deuxième étape consistant en un balayage de la surface de ladite couche par un faisceau laser dans un environnement contenant du carbone, ledit balayage étant effectué de manière telle que l'élévation de la température desdites pièces reste modérée.

2. Procédé selon la revendication 1, caractérisé en ce que la première étape est réalisée par voie galvanique.

3. Procédé selon la revendication 1, caractérisé en ce que la première étape est réalisée par évaporation.

4. Procédé selon la revendication 1, caractérisé en ce que la première étape est réalisée par pulvérisation par plasma.

5. Procédé selon la revendication 1, caractérisé en ce que la première étape est réalisée par pulvérisation ionique.

6. Procédé selon la revendication 1, caractérisé en ce que l'environnement carburant est constitué par une couche déposée comportant du carbone.

7. Procédé selon la revendication 1, caractérisé en ce que l'environnement carburant est constitué par un gaz contenant du carbone.

8. Procédé selon la revendication 1, caractérisé en ce que ladite couche contient du tungstène.

9. Procédé selon la revendication 1, caractérisé en ce que ladite couche contient du chrome.

10. Pièces revêtues par une couche dure et résistante à l'usure, caractérisée en ce que ladite couche comprend au moins un carbure d'un élément métallique obtenu par le procédé selon l'une des revendications 1 à 9.